# EUROPEAN PATENT APPLICATION

(11) **EP 4 742 281 A1**
(43) Date of publication of application: **13.05.2026**
(21) Application number: 24895561.9
(22) Date of filing: 17.06.2024
(51) Int. Cl.: H01F 7/02

(54) **MAGNETIC ATTRACTION ASSEMBLY AND ASSEMBLING METHOD THEREFOR, LINEAR MOTOR, CAMERA, AND ELECTRONIC DEVICE**

(30) Priority: 27.11.2023 CN 202311602953
(71) Applicant: Huawei Technologies Co., Ltd., Shenzhen, Guangdong 518129 (CN)
(72) Inventor: LUO, Jixing, Shenzhen, Guangdong 518129 (CN); ZHANG, Jianguang, Shenzhen, Guangdong 518129 (CN); WANG, Yake, Shenzhen, Guangdong 518129 (CN); YAN, Xiaolin, Shenzhen, Guangdong 518129 (CN); CHEN, Hong, Shenzhen, Guangdong 518129 (CN); LIU, Bin, Shenzhen, Guangdong 518129 (CN)
(74) Representative: Körber, Martin Hans
(86) International application number: PCT/CN2024/099650
(87) International publication number: WO 2025/112458

(57) **Abstract**

This application relates to the field of bendable circuit board technologies, and provides a magnetic attraction component and an assembly method thereof, a linear motor, a camera, and an electronic device, to resolve problems in a related technology that reliability of a connection between two magnets that repulse each other in the magnetic attraction component is low and assembly efficiency of the magnetic attraction component is low. The magnetic attraction component includes a magnet unit. The magnet unit includes a plurality of magnets. Two adjacent magnets, in the plurality of magnets, that repulse each other are welded. This application may be applied to an electronic device such as a mobile phone.

## Description

This application claims priority to Chinese Patent Application No. 202311602953.0, filed with the China National Intellectual Property Administration on November 27, 2023 and entitled "MAGNETIC ATTRACTION COMPONENT AND ASSEMBLY METHOD THEREOF, LINEAR MOTOR, CAMERA, AND ELECTRONIC DEVICE", which is incorporated herein by reference in its entirety.

### TECHNICAL FIELD

This application relates to the field of magnetic attraction technologies, and in particular, to a magnetic attraction component and an assembly method thereof, a linear motor, a camera, and an electronic device.

### BACKGROUND

Magnetic attraction components such as Halbach arrays are widely used in apparatuses such as linear motors due to good magnetic attraction effect of the magnetic attraction components. The magnetic attraction component is usually formed by arranging and assembling a plurality of magnets according to a specific rule. How to reliably assemble the plurality of magnets together directly affects normal operation of the magnetic attraction component. In a magnetic attraction component in a related technology, for example, the Halbach array, two magnets that repulse each other are bonded together through a glue layer. However, strength of a connection between the two adjacent magnets that are bonded through the glue layer is low, and the two magnets are easily detached due to a repulsion force over time. This reduces reliability of the connection between the two magnets that repulse each other, and affects normal operation of the magnetic attraction component. In addition, the magnets are bonded through the glue layer. In an assembly process, the glue layer needs to be baked to enable the glue layer to be cured. This occupies much time, and is not conducive to improving assembly efficiency.

Embodiments of this application provide a magnetic attraction component and an assembly method thereof, a linear motor, a camera, and an electronic device, to resolve problems in a related technology that reliability of a connection between two magnets that repulse each other in the magnetic attraction component is low and assembly efficiency of the magnetic attraction component is low.

To achieve the foregoing objectives, the following technical solutions are used in embodiments of this application.

According to a first aspect, an embodiment of this application provides a magnetic attraction component that includes a magnet unit. The magnet unit includes a plurality of magnets. Two adjacent magnets that repulse each other are welded in the plurality of magnets. Through such a disposition, a connection between the magnets that repulse each other is closer, and strength of the connection is higher, thereby improving reliability of the connection between the magnets that repulse each other, and further ensuring normal operation of the magnetic attraction component. In addition, the magnets that repulse each other are welded, so that a process that occupies long time, such as baking, can be omitted, thereby helping improve assembly efficiency of the magnetic attraction component.

In some embodiments, a joint of the two adjacent magnets that repulse each other has a welding bonding portion, and the welding bonding portion connects the two adjacent magnets that repulse each other together. Through such a disposition, this is more conducive to connecting the magnets together, thereby helping improve the strength of the connection between the magnets.

In some embodiments, the magnet unit is a Halbach array, each magnet includes a first end surface and a second end surface that are disposed opposite to each other, and first magnet side surfaces connected between the first end surface and the second end surface, the first end surface is a surface of a strong magnetic side, on which the magnet is located, of the magnet unit, the second end surface is a surface of a weak magnetic side, on which the magnet is located, of the magnet unit, the first magnet side surfaces are separately located at two opposite ends of the magnet in a first direction, and the first direction is perpendicular to an arrangement direction of the magnets in the magnet unit. In the two adjacent magnets, a joint of the first magnet side surfaces of the magnets has the welding bonding portion, and/or a joint of the second end surfaces of the magnets has the welding bonding portion. Impact of welding on magnetism of the magnet unit can be reduced through such a disposition.

In some embodiments, the magnet unit includes two magnets, the two magnets are: a first magnet and a second magnet, the first magnet includes a first magnet subportion and a second magnet subportion, the first magnet subportion and the second magnet subportion are of an integrated structure, the second magnet subportion is located between the first magnet subportion and the second magnet, a pole of the first magnet subportion is opposite to a pole of the second magnet, and a pole of the second magnet subportion is perpendicular to the pole of the first magnet subportion. A structure of the magnet unit can be more compact through such a disposition, thereby helping improve assembly efficiency of the magnet unit.

In some embodiments, in the magnet unit, each magnet includes two magnet end surfaces disposed opposite to each other, and first magnet side surfaces connected between the two magnet end surfaces, and the magnets have a same pole direction that points from one of the two magnet end surfaces to the other magnet end surface. The first magnet side surfaces are separately located at two opposite ends of the magnet in a first direction, and the first direction is perpendicular to an arrangement direction of the magnets in the magnet unit. In the two adjacent magnets, a joint of the first magnet side surfaces of the magnets has the welding bonding portion. Impact of welding on magnetism of the magnet unit can be reduced through such a disposition.

In some embodiments, there are a plurality of magnet units, the plurality of magnet units are arranged in the arrangement direction of magnets in the magnet units, pole directions of magnets in two adjacent magnet units are opposite, and a joint of the first magnet side surfaces of the two adjacent magnet units has the welding bonding portion. A connection between the two adjacent magnet units can be firmer through such a disposition, thereby improving reliability of the connection between the magnet units.

In some embodiments, the welding bonding portion is of a strip structure and extends along a seam between the magnets. A length for joining the magnets in an extension direction of the seam can be increased through such a disposition, thereby helping improve the strength of the connection between the magnets.

In some embodiments, the welding bonding portion is in a wave shape along the seam between the magnets. A length for joining the magnets in a width direction of the seam can be increased through such a disposition, thereby helping improve the strength of the connection between the magnets.

In some embodiments, an end portion of the welding bonding portion is disposed at an interval from an edge of the magnet along the seam between the magnets. Damage to the edge of the magnet caused by high temperature or the like in a process of forming the welding bonding portion during welding can be avoided through such a disposition.

In some embodiments, there are a plurality of welding bonding portions, and the plurality of welding bonding portions are spaced along seams between the magnets. Space occupied by the welding bonding portions is reduced through such a disposition, so that deformation of the magnets during welding is small.

In some embodiments, the welding bonding portion has a spiral pattern, and the pattern extends from a central region of the welding bonding portion to an edge region of the welding bonding portion. An area of the welding bonding portion can be expanded through such a disposition, so that the connection between the magnets is firmer.

In some embodiments, the magnetic attraction component further includes a magnet mounting bracket, an accommodating groove is disposed on the magnet mounting bracket, a groove bottom wall of the accommodating groove is covered with a magnetic conductive sheet, and at least a part of the magnet unit is disposed in the accommodating groove. The magnets in the magnet unit can be more closely joined through such a disposition, thereby avoiding separation of the magnets.

According to a second aspect, an embodiment of this application provides a linear motor, including a stator, a mover, a drive coil, and the magnetic attraction component according to the first aspect. The drive coil is disposed on one of the stator and the mover, and the magnetic attraction component is disposed on the other of the stator and the mover.

Beneficial effect of the linear motor in this embodiment of this application are the same as beneficial effect of the magnetic attraction component according to the first aspect. Details are not described herein again.

According to a third aspect, an embodiment of this application provides a camera, including an optical lens, a photosensitive element, and the linear motor according to the second aspect. The optical lens is fastened to the mover of the linear motor, the photosensitive element is disposed on an image side of the optical lens, and the photosensitive element is relatively fastened to the stator of the linear motor in an axial direction of the optical lens.

Beneficial effect of the camera in this embodiment of this application are the same as beneficial effect of the magnetic attraction component according to the first aspect. Details are not described herein again.

According to a fourth aspect, an embodiment of this application provides an electronic device, including a housing and the camera according to the third aspect. The camera is disposed on the housing.

Beneficial effect of the electronic device in this embodiment of this application are the same as beneficial effect of the magnetic attraction component according to the first aspect. Details are not described herein again.

According to a fifth aspect, an embodiment of this application provides an assembly method for a magnetic attraction component, including: welding two adjacent magnets that repulse each other in a magnet unit in the magnetic attraction component. The magnet unit includes a plurality of magnets, and the plurality of magnets in the magnet unit are placed on a carrying surface of a carrier.

Beneficial effect of the assembly method for a magnetic attraction component in this embodiment of this application are the same as beneficial effect of the magnetic attraction component according to the first aspect. Details are not described herein again.

In some embodiments, the magnet unit is a Halbach array, each magnet includes a first end surface and a second end surface that are disposed opposite to each other, and first magnet side surfaces connected between the first end surface and the second end surface, the first end surface is located on a strong magnetic side of the magnet unit, the second end surface is located on a weak magnetic side of the magnet unit, the first magnet side surfaces are separately located at two opposite ends of the magnet in a first direction, and the first direction is perpendicular to an arrangement direction of the magnets in the magnet unit. Welding the two adjacent magnets that repulse each other in the magnet unit in the magnetic attraction component includes: performing welding at a joint of welding surfaces of the two adjacent magnets. The welding surface is located on a side that is of the magnet and that is away from the carrying surface, and the welding surface is the second end surface or the first magnet side surface. Impact of welding on magnetism of the magnet unit can be reduced through such a disposition.

In some embodiments, the carrier includes a carrying body and a movable carrying platform, an accommodating hole is disposed on the carrying body, the movable carrying platform is disposed in the accommodating hole and may be separated from the carrying body, and the movable carrying platform is configured to be disposed with the magnet unit. After welding is performed at the joint of the welding surfaces of the two adjacent magnets, the method further includes: separating the movable carrying platform from the carrying body; moving the movable carrying platform to be above of the magnet mounting bracket, and rotating the movable carrying platform by a given angle, to enable the first end surface of the magnet to be away from a groove bottom wall of an accommodating groove on the magnet mounting bracket; and separating the movable carrying platform from the magnet unit to place the magnet unit in the accommodating groove of the magnet mounting bracket. Direct contact between a transfer mechanism and the magnet unit can be avoided through such a disposition, thereby reducing damage caused by an external force to the magnet unit in a process of placing the magnet unit on the magnet mounting bracket.

In some embodiments, the movable carrying platform includes a carrying platform body and magnet snapping members that can be movably disposed on two opposite sides of the carrying platform body, there are three magnets in the magnet unit, a magnet located in a middle is located on the carrying platform body, parts of magnets located on two sides are located on the carrying platform body, the other parts of the magnets are located on the corresponding magnet snapping members, and each magnet snapping member snaps to the corresponding magnet. Separating the movable carrying platform from the magnet unit includes: adjusting a location of each magnetic snapping member relative to the carrying platform body, to enable each magnetic snapping member to be separated from the corresponding magnet. Damage caused by an external force to the magnet unit in a process of separating the magnet unit from the movable carrying platform can be reduced through such a disposition.

In some embodiments, before welding the two adjacent magnets that repulse each other in the magnet unit in the magnetic attraction component, the method further includes: covering a protection cover on the plurality of magnets. An avoidance hole is disposed on the cover, and the avoidance hole is opposite to a welding part on the magnet. The cover plate can protect a non-welding part of the magnet through such a disposition, thereby avoiding damage caused by a welding device to the non-welding part of the magnet in a welding process.

### BRIEF DESCRIPTION OF DRAWINGS

FIG. 1 is a distribution diagram of magnetic induction lines of a strip magnet;
FIG. 2 is a distribution diagram of magnetic induction lines of a Halbach array;
FIG. 3 is a distribution diagram of magnetic induction lines of another Halbach array;
FIG. 4 is a diagram of a structure of a magnetic attraction component in a related technology;
FIG. 5 is a diagram of an assembly process of the magnetic attraction component in FIG. 4;
FIG. 6 is a diagram of another assembly process of the magnetic attraction component in FIG. 4;
FIG. 7 is a diagram of a structure of a magnetic attraction component according to a first embodiment of this application;
FIG. 8 is a bottom view of the magnetic attraction component shown in FIG. 7;
FIG. 9 is a diagram of a structure of a magnetic attraction component according to a second embodiment of this application;
FIG. 10 is a diagram of a structure of a magnetic attraction component according to a third embodiment of this application;
FIG. 11 is a diagram of a structure of a magnetic attraction component according to a fourth embodiment of this application;
FIG. 12 is a diagram of a structure of a magnetic attraction component according to a fifth embodiment of this application;
FIG. 13 is a diagram of a structure of a magnetic attraction component according to a sixth embodiment of this application;
FIG. 14 is a diagram of a structure of a magnetic attraction component according to a seventh embodiment of this application;
FIG. 15 is a diagram of a structure of a magnetic attraction component according to an eighth embodiment of this application;
FIG. 16 is a diagram of a structure of a magnetic attraction component according to a ninth embodiment of this application;
FIG. 17 is a diagram of a structure of a magnetic attraction component according to a tenth embodiment of this application;
FIG. 18 is a diagram of a structure of a magnetic attraction component according to an eleventh embodiment of this application;
FIG. 19 is a diagram of a structure of a magnetic attraction component according to a twelfth embodiment of this application;
FIG. 20 is a diagram of an assembly process of a magnetic attraction component according to some embodiments of this application;
FIG. 21 is a diagram of a structure of a movable carrying platform according to some embodiments of this application;
FIG. 22 is a diagram of a structure of a camera according to some embodiments of this application;
FIG. 23 is an A-A sectional view of the camera in FIG. 22;
FIG. 24 is a diagram of a back of an electronic device according to some embodiments of this application; and
FIG. 25 is a B-B cross-sectional view of the electronic device shown in FIG. 24.

### DESCRIPTION OF EMBODIMENTS

The technical solutions according to some embodiments of this application are clearly and completely described in the following with reference to the accompanying drawings.

To facilitate understanding of a working principle of a magnetic attraction component in embodiments of this application, the following first describes a magnetic induction feature of a magnet and a Halbach array (Halbach array).

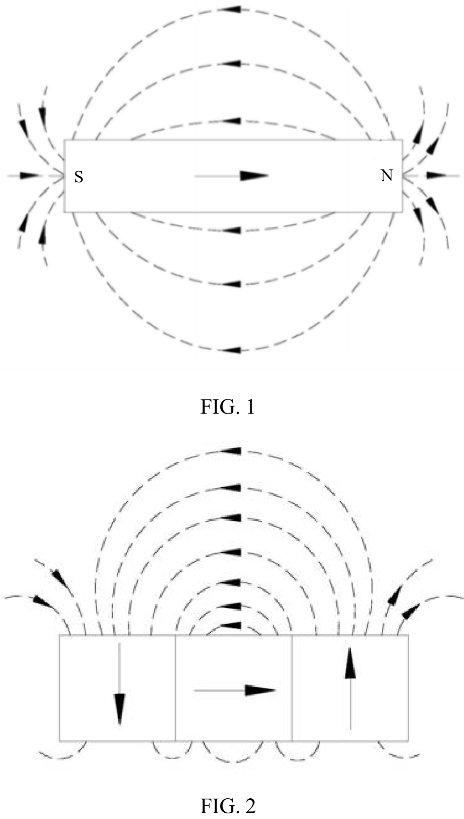

FIG. 1 is a distribution diagram of magnetic induction lines of a strip magnet. A left end of the magnet is an S pole, and a right end is an N pole. A solid line arrow in the magnet in the figure represents a pole direction (that is, a magnetic pole direction) of the magnet, that is, a direction from the S pole to the N pole inside the magnet. When the magnet is a magnetizable magnet, the pole direction of the magnet may also be referred to as a magnetizing direction. Dashed lines in the figure represent distribution of magnetic induction lines of a magnetic field formed outside the magnet. To be specific, the magnetic induction lines start, outside the magnet, from the N pole of the magnet and return to the S pole of the magnet.

A Halbach array is of a magnet structure, which is an engineering-approximate ideal structure. A principle of the Halbach array is using magnets arranged according to a given rule to enhance magnetic field strength in a unit direction, to generate a strongest magnetic field based on a minimum quantity of magnets. FIG. 2 is a distribution diagram of magnetic induction lines of a Halbach array. The Halbach array includes three magnets that are sequentially arranged. Three solid line arrows in the figure respectively represent pole directions of the three magnets. Magnetic fields formed by the three magnets affect each other, so that magnetic field strength on an upper side is effectively increased, and magnetic field strength on a lower side is effectively reduced. In the Halbach array, a side with strong magnetic field strength is referred to as a strong magnetic side, and a side with weak magnetic field strength is referred to as a weak magnetic side. For example, in FIG. 2, the upper side of the Halbach array is the strong magnetic side, and the lower side is the weak magnetic side.

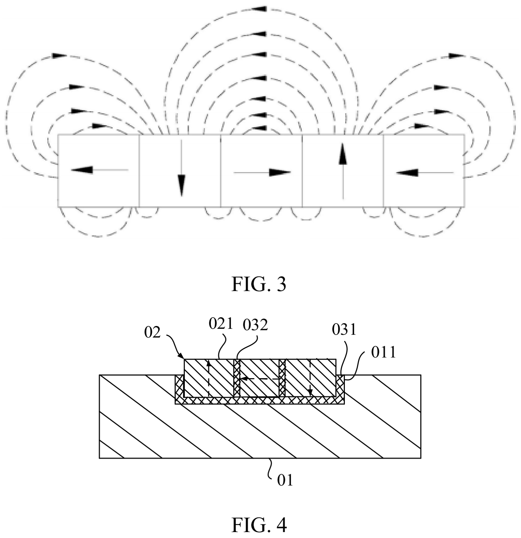

Certainly, the Halbach array is not limited to the arrangement and combination shown in FIG. 2. For example, FIG. 3 is a distribution diagram of magnetic induction lines of another Halbach array. The Halbach array includes five magnets that are sequentially arranged. Five solid line arrows in the figure respectively represent pole directions of the five magnets. Magnetic fields formed by the five magnets affect each other, so that magnetic field strength on an upper side of the Halbach array is effectively increased, and magnetic field strength on a lower side is effectively reduced.

FIG. 4 is a diagram of a structure of a magnetic attraction component in a related technology. The magnetic attraction component includes a magnet mounting bracket 01 and a magnet unit 02. An accommodating groove 011 is disposed on the magnet mounting bracket 01, the magnet unit 02 is disposed in the accommodating groove 011, and a first glue layer 031 is disposed between the magnet unit 02 and a groove wall of the accommodating groove 011, to bond and fasten the magnet unit 02 to the magnet mounting bracket 01.

The magnet unit 02 is a Halbach array, and includes three magnets 021 that are sequentially arranged. Because a repulsion force exists between two adjacent magnets 021, a second glue layer 032 is disposed between the two adjacent magnets 021, and the second glue layer 032 is used to bond and fasten the two adjacent magnets 021. A side (that is, an upper side in the figure), of the magnet unit 02, that is away from a groove bottom wall of the accommodating groove 011 is a strong magnetic side, and a side (that is, a lower side in the figure), of the magnet unit 02, that is close to the groove bottom wall of the accommodating groove 011 is a weak magnetic side.

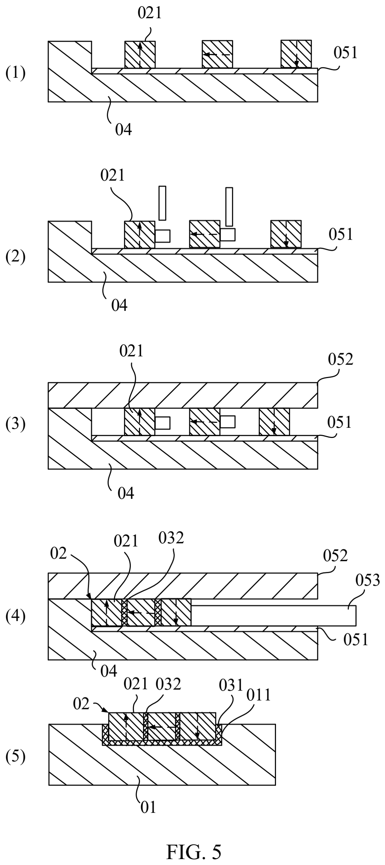

FIG. 5 is a diagram of an assembly process of the magnetic attraction component in FIG. 4. An assembly method for a magnetic attraction component includes the following steps:
M1: As shown in (1) in FIG. 5, dispose a plurality of magnets 021 in the magnet unit 02 on a magnetic conductive sheet 051 of a carrier disk 04.
M2: As shown in (2) in FIG. 5, dispense glue on a side wall of each magnet 021.
M3: As shown in (3) in FIG. 5, dispose a magnetic conductive rod 052 on a top of each magnet 021.
M4: As shown in (4) in FIG. 5, push and press sides of the plurality of magnets 021 via a push rod 053, to form the magnet unit 02, and bake the magnet unit 02, so that glue dispensed between two adjacent magnets 021 is cured to form the second glue layer 032.
M5: As shown in (5) in FIG. 5, dispose the magnet unit 02 in the accommodating groove 011 of the magnet mounting bracket 01, and bond and fasten the magnet unit 02 in the accommodating groove 011 through the first glue layer 031.

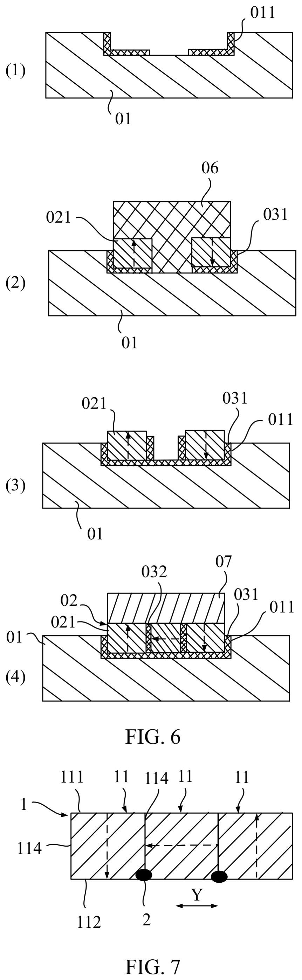

FIG. 6 is a diagram of another assembly process of the magnetic attraction component in FIG. 4. A main difference between an assembly method shown in FIG. 6 and the assembly method shown in FIG. 5 lies in that in the assembly method shown in FIG. 6, the magnet 021 is directly assembled with the magnet mounting bracket 01. Specifically, the assembly method for a magnetic attraction component includes the following steps:
N1: As shown in (1) in FIG. 6, dispose glue materials at two ends of the accommodating groove 011 of the magnet mounting bracket 01.
N2: As shown in (2) in FIG. 6, place magnets 021 on two sides respectively at the two ends of the accommodating groove 011, pressurize the magnets 021 on the two sides via a magnetic isolation jig 06, and perform baking, so that the glue materials between the magnets 021 on the two sides and the groove wall of the accommodating groove 011 are cured to form the first glue layer 031.
N3: As shown in (3) in FIG. 6, remove the magnetic isolation jig 06, and dispense glue in a middle region of the accommodating groove 011 and side walls of the magnets 021 on the two sides.
N4: As shown in (4) in FIG. 6, place a middle magnet 021 between the magnets 021 on the two sides, pressurize the middle magnet 021 via a pressurization jig 07, and perform baking, so that glue dispensed between the magnets 021 on the two sides and the middle magnet 021 is cured to form the second glue layer 032, and glue dispensed between the middle magnet 021 and the groove wall of the accommodating groove 011 is cured to form the first glue layer 031.

In the magnetic attraction component in the related technology, strength of a connection of bonding between the two adjacent magnets 021 in the magnet unit 02 via the second glue layer 032 is low, a closeness degree of bonding between the second glue layer 032 and the magnet 021 is reduced over time, and the two magnets 021 are easily detached due to the repulsion force. This reduces reliability of the connection between the two magnets 021 that repulse each other, and affects normal operation of the magnetic attraction component. In addition, the magnets 021 are bonded through the glue layer. In the assembly process, the glue layer needs to be baked to enable the glue layer to be cured. This occupies much time, and is not conducive to improving assembly efficiency.

Therefore, embodiments of this application provide a magnetic attraction component and an assembly method thereof, a linear motor, a camera, and an electronic device. Two adjacent magnets that repulse each other in a magnet unit are welded together. Strength of a connection between the magnets that repulse each other is improved, and assembly efficiency of the magnetic attraction component is improved, to resolve problems in the related technology that reliability of the connection between the magnets that repulse each other in the magnetic attraction component is low and the assembly efficiency of the magnetic attraction component is low.

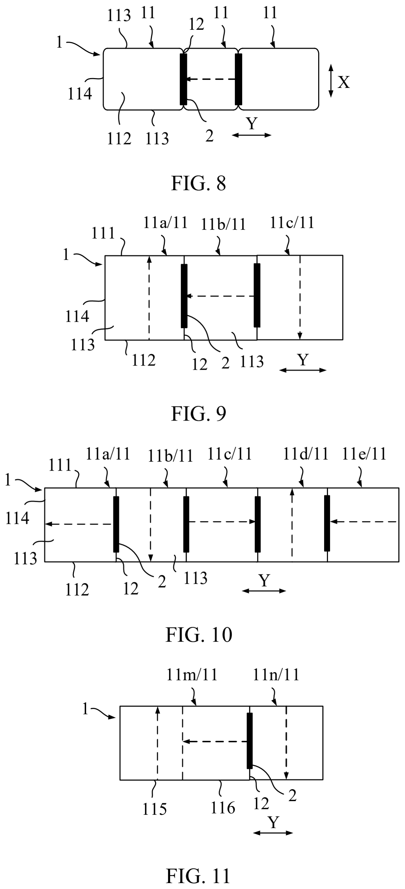

As shown in FIG. 7 and FIG. 8, FIG. 7 is a diagram of a structure of a magnetic attraction component according to a first embodiment of this application, and FIG. 8 is a bottom view of the magnetic attraction component shown in FIG. 7. The magnetic attraction component includes a magnet unit 1. The magnet unit 1 is a Halbach array, and includes a plurality of magnets 11. Two adjacent magnets 11, in the plurality of magnets 11, that repulse each other are welded.

A material of the magnet 11 may be a neodymium iron boron (NdFe₁₄B) magnet, but is not limited thereto. Alternatively, another magnetic material that can be welded may be used, for example, a natural magnet (Fe₃O₄).

As shown in FIG. 7, each magnet 11 includes a first end surface 111 and a second end surface 112 that are disposed opposite to each other, and first magnet side surfaces 113 and second magnet side surfaces 114 connected between the first end surface 111 and the second end surface 112, the first end surface 111 is a surface on which the magnet 11 is located on a strong magnetic side (for example, an upper side shown in FIG. 7) of the magnet unit 1, and the second end surface 112 is a surface on which the magnet 11 is located on a weak magnetic side (for example, a lower side shown in FIG. 7) of the magnet unit 1. As shown in FIG. 8, the first magnet side surfaces 113 are separately located at two opposite ends of the magnet 11 in a first direction X, and the first direction X is perpendicular to an arrangement direction Y of the magnets 11 in the magnet unit 1. The second magnet side surfaces 114 are separately located at two opposite ends of the magnets 11 in the arrangement direction Y of the magnets 11, and second magnet side surfaces 114 of two adjacent magnets 11 are connected.

Certainly, the magnet 11 is not limited to the structure shown in FIG. 7, and another shape may alternatively be used for the magnet 11 based on an actual case.

The two adjacent magnets 11 that repulse each other are connected together through welding (for example, fusion welding) as opposed to bonding through a glue layer. A connection between the magnets 11 that repulse each other is closer, and strength of the connection is higher, thereby improving reliability of the connection between the magnets 11 that repulse each other, and further ensuring normal operation of the magnetic attraction component. In addition, because the magnets 11 that repulse each other are welded, a process that occupies long time, such as baking, can be omitted, thereby helping improve assembly efficiency of the magnetic attraction component.

In addition, the two magnets 11 that repulse each other are welded together, and may be welded after the two magnets 11 that repulse each other press against each other. In this way, a problem that the middle magnet 021 in the assembly method shown in FIG. 6 cannot be assembled due to overflowed glue is avoided, so that assembly consistency of the magnet unit 1 is good.

In some embodiments, as shown in FIG. 7 and FIG. 8, a joint of the two adjacent magnets 11 that repulse each other has a welding bonding portion 2, and the welding bonding portion 2 connects the two adjacent magnets 11 that repulse each other together.

The welding bonding portion 2 is a portion, of the magnet 11, on which fusion welding is partially performed in a manner of heating, high temperature, high pressure, or the like. For example, the magnet 11 is partially melt to form a molten puddle, and the molten puddle is cooled and cured to form the welding bonding portion 2. The two magnets 11 that repulse each other may be formed through a plurality of welding processes, such as laser welding, tin welding, argon arc welding, resistance welding, and ultrasonic welding.

The welding bonding portion 2 is disposed at the joint of the magnets 11, which is more conducive to connecting the magnets 11 together, thereby helping improve the strength of the connection between the magnets 11, and further improving the reliability of the connection between the magnets 11 that repulse each other.

The welding bonding portion 2 is not disposed at a unique location. In some embodiments, as shown in FIG. 7 and FIG. 8, in the two adjacent magnets 11, the welding bonding portion 2 is disposed at a joint of the second end surfaces 112 of the magnets 11, in other words, the welding bonding portion 2 is located on the weak magnetic side of the magnet unit 1. Impact of high temperature or the like on an operating surface (a surface of the strong magnetic side) of the magnet unit 1 in a welding process can be reduced through such a disposition, thereby reducing impact of welding on magnetism of the magnet unit 1.

In some embodiments, as shown in FIG. 9 and FIG. 10, FIG. 9 is a diagram of a structure of a magnetic attraction component according to a second embodiment of this application, and FIG. 10 is a diagram of a structure of a magnetic attraction component according to a third embodiment of this application. In the two adjacent magnets 11, a joint of the first magnet side surfaces 113 of the magnets 11 has the welding bonding portion 2. The impact of the high temperature or the like on the operating surface of the magnet unit 1 in the welding process can be reduced through such a disposition, thereby reducing the impact of welding on the magnetism of the magnet unit 1.

In addition to the foregoing disposition location, the welding bonding portion 2 may alternatively be disposed at a joint of first end surfaces 111 of the magnets 11, in other words, the welding bonding portion 2 is located on the strong magnetic side of the magnet unit 1. The welding bonding portion 2 may alternatively be disposed at least two of the following locations: the joint of the first end surfaces 111 of the magnets 11, the joint of second end surfaces 112 of the magnets 11, and the joint of the first magnet side surfaces 113 of the magnets 11.

A quantity of magnets 11 in the magnet unit 1 may be set in a plurality of manners. As shown in FIG. 9, in some embodiments, the magnet unit 1 includes three magnets 11. The three magnets 11 are: a magnet 11a, a magnet 11b, and a magnet 11c. The magnet 11a, the magnet 11b, and the magnet 11c are sequentially arranged. A pole direction of the magnet 11a points to the strong magnetic side of the magnet unit 1, that is, an upper side in the figure. A pole direction of the magnet 11b is perpendicular to the pole direction of the magnet 11a, and points to a side of the magnet 11a, that is, a left side in the figure. A pole direction of the magnet 11c points to the weak magnetic side of the magnet unit 1, that is, a lower side in the figure.

In some embodiments, as shown in FIG. 10, the magnet unit 1 includes five magnets 11. The five magnets 11 are: a magnet 11a, a magnet 11b, a magnet 11c, a magnet 11d, and a magnet 11e, and the magnet 11a, the magnet 11b, the magnet 11c, the magnet 11d, and the magnet 11e are sequentially arranged. A pole direction of the magnet 11b points to the weak magnetic side of the magnet unit 1, that is, a lower side in the figure. A pole direction of the magnet 11a is perpendicular to the pole direction of the magnet 11b, and points to a side away from the magnet 11b, that is, a left side in the figure. A pole direction of the magnet 11c is perpendicular to the pole direction of the magnet 11b, and points to a side away from the magnet 11b, that is, a right side in the figure. A pole direction of the magnet 11d points to the strong magnetic side of the magnet unit 1, that is, an upper side in the figure. A pole direction of the magnet 11e is perpendicular to the pole direction of the magnet 11d, and points to a side on which the magnet 11d is located, that is, the left side in the figure.

In some embodiments, FIG. 11 is a diagram of a structure of a magnetic attraction component according to a fourth embodiment of this application. The magnet unit 1 includes two magnets 11, the two magnets 11 are: a first magnet 11m and a second magnet 11n, the first magnet 11m includes a first magnet subportion 115 and a second magnet subportion 116, the first magnet subportion 115 and the second magnet subportion 116 are of an integrated structure, the second magnet subportion 116 is located between the first magnet subportion 115 and the second magnet 11n, a pole direction of the first magnet subportion 115 is opposite to a pole direction of the second magnet 11n, and a pole direction of the second magnet subportion 116 is perpendicular to the pole direction of the first magnet subportion 115.

Because the first magnet subportion 115 and the second magnet subportion 116 are of the integrated structure, the first magnet 11m has two vertical pole directions. A structure of the magnet unit 1 may be more compact through such a disposition, and the quantity of magnets 11 in the magnet unit 1 may be reduced, thereby helping improve assembly efficiency of the magnet unit 1, to further improve the assembly efficiency of the magnetic attraction component.

In some embodiments, as shown in FIG. 11, the pole direction of the first magnet subportion 115 points to the strong magnetic side of the magnet unit 1, that is, an upper side in the figure. The pole direction of the second magnet subportion 116 is perpendicular to the pole direction of the first magnet subportion 115, and points to a side on which the first magnet subportion 115 is located, that is, a left side in the figure. The pole direction of the second magnet 11n points to the weak magnetic side of the magnet unit 1, that is, a lower side in the figure.

Certainly, in the magnet unit 1, the quantity of magnets 11 is not limited to two, three, or five, and more than five magnets 11 may alternatively be disposed based on an actual case.

A shape of the welding bonding portion 2 is not unique. In some embodiments, as shown in FIG. 8 to FIG. 11, the welding bonding portion 2 is of a strip structure and extends along a seam 12 between the magnets 11. A size of the welding bonding portion 2 in an extension direction of the seam 12 is L, and a size of the welding bonding portion 2 in a width direction of the seam 12 is W. That the welding bonding portion 2 is of the strip structure specifically means that a value of L/W is greater than or equal to 2.

The welding bonding portion 2 is disposed as the strip structure extending along the seam 12. In this way, a length for joining the magnets 11 in the extension direction of the seam 12 can be increased, thereby helping improve the strength of the connection between the magnets 11, and further helping improve the reliability of the connection between the magnets 11 that repulse each other.

The welding bonding portion 2 of the strip structure has a plurality of forms. For example, in some embodiments, as shown in FIG. 8 to FIG. 11, the welding bonding portion 2 is a straight strip structure, and an extension direction of the welding bonding portion 2 is parallel to the extension direction of the seam 12, that is, a welding path of the magnets 11 is a straight line during welding.

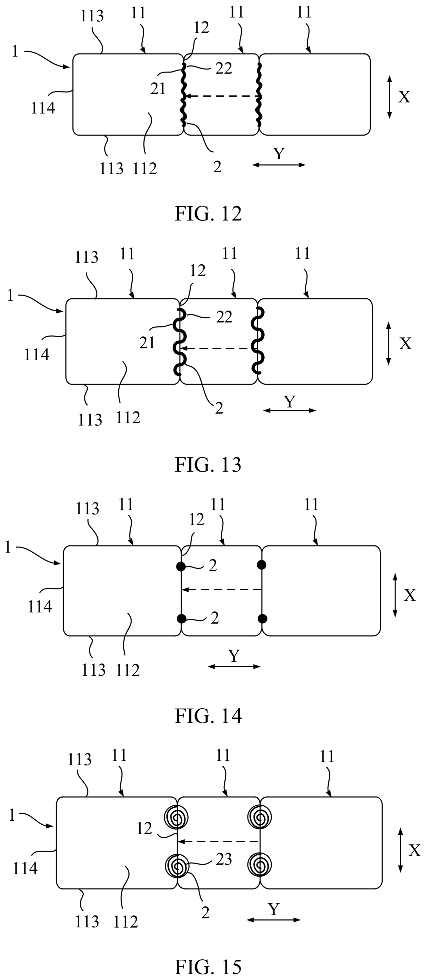

In some other embodiments, as shown in FIG. 12 and FIG. 13, FIG. 12 is a diagram of a structure of a magnetic attraction component according to a fifth embodiment of this application, and FIG. 13 is a diagram of a structure of a magnetic attraction component according to a sixth embodiment of this application. The welding bonding portion 2 is of a wavy strip structure. Specifically, the welding bonding portion 2 is in a wave shape along the seam 12. In other words, the welding path of the magnets 11 is a wavy line (that is, whipping welding). The wavy line may be a sine curve (as shown in FIG. 13) or a cosine curve, or may be another irregular fluctuation curve (as shown in FIG. 12). A width for joining the magnets 11 in the width direction (for example, the Y direction in FIG. 12 and FIG. 13) of the seam 12 can be increased through such a disposition, thereby helping improve the strength of the connection between the magnets 11, and further helping improve the reliability of the connection between the magnets 11 that repulse each other.

As shown in FIG. 12 and FIG. 13, the welding bonding portion 2 includes first curved portions 21 and second curved portions 22. The first curved portions 21 and the second curved portions 22 are alternately arranged along the seam 12 between the magnets 11, the first curved portion 21 bends towards one side of the seam 12, and the second curved portion 22 bends towards the other side of the seam 12.

In some embodiments, as shown in FIG. 11 and FIG. 12, end portions of the welding bonding portion 2 and edges of the magnet 11 are spaced along the seam 12. For example, as shown in FIG. 12, an upper end of the welding bonding portion 2 and an upper edge (that is, a first magnet side surface 113 on an upper side) of the magnet 11 are spaced, and a lower end of the welding bonding portion 2 and a lower edge (that is, a first magnet side surface 113 on a lower side) of the magnet 11 are spaced. Damage to the edge of the magnet 11 caused by the high temperature or the like in a process of forming the welding bonding portion 2 during welding can be avoided through such a disposition.

In some embodiments, as shown in FIG. 14 and FIG. 15, FIG. 14 is a diagram of a structure of a magnetic attraction component according to a seventh embodiment of this application, and FIG. 15 is a diagram of a structure of a magnetic attraction component according to an eighth embodiment of this application. There are a plurality of welding bonding portions 2, and the plurality of welding bonding portions 2 are spaced along seams 12 between the magnets 11. Space occupied by the welding bonding portions 2 is reduced in the extension direction of the seam 12 through such a disposition. In this way, deformation of the magnets 11 during welding is small, and impact caused, on the magnetism of the magnet 11, by the high temperature or the like of the welding bonding portion 2 during forming is also reduced.

As shown in FIG. 14 and FIG. 15, at a same seam 12, two welding bonding portions 2 may be disposed, and this is not limited thereto. Alternatively, three or more welding bonding portions 2 may be disposed. As shown in FIG. 14 and FIG. 15, a shape of a contour of the welding bonding portion 2 may be a circle, but is not limited thereto, or may be an ellipse, a square, a rectangle, or the like.

In some embodiments, as shown in FIG. 15, the welding bonding portion 2 has a spiral pattern 23, and the pattern 23 extends from a central region of the welding bonding portion 2 to an edge region of the welding bonding portion 2. In other words, the welding path of the magnets 11 is a spiral line (that is, spiral welding) during welding. An area of the welding bonding portion 2 can be expanded through such a disposition, so that the connection between the magnets 11 is firmer, and the reliability of the connection between the magnets 11 can be improved.

As shown in FIG. 15, the pattern 23 is a welding path mark left after welding. For example, when the magnets 11 are welded through laser, the pattern 23 is a path mark left after laser welding.

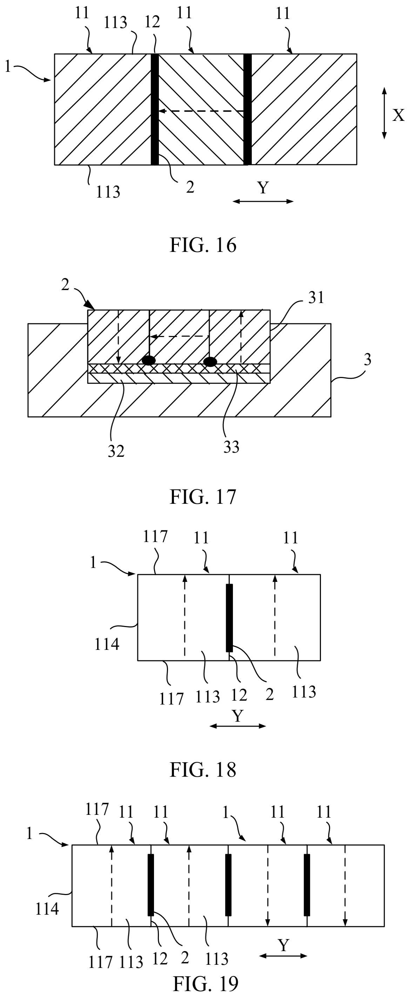

In some embodiments, FIG. 16 is a diagram of a structure of a magnetic attraction component according to a ninth embodiment of this application. The welding bonding portion 2 penetrates the magnet unit 1 in a depth direction (for example, an X direction in the figure) of the seam 12. In other words, when the magnets 11 are welded, a welding path is disposed between two ends of a length direction of the seam 12 in an overlapping manner (that is, lap welding), so that the magnets 11 in the depth direction of the seam 12 can be fully welded.

The welding bonding portion 2 may penetrate the magnet unit 1 in the first direction X, or may penetrate the magnet unit 1 in a height direction of the magnet unit 1. The height direction of the magnet unit 1 is perpendicular to both the first direction X and the arrangement direction Y of the magnets 11.

In some embodiments, FIG. 17 is a diagram of a structure of a magnetic attraction component according to a tenth embodiment of this application. The magnetic attraction component further includes a magnet mounting bracket 3, an accommodating groove 31 is disposed on the magnet mounting bracket 3, a groove bottom wall of the accommodating groove 31 is covered with a magnetic conductive sheet 32, and at least a part of the magnet unit 1 is disposed in the accommodating groove 31.

The accommodating groove 31 can limit a location of the magnet unit 1 by disposing the magnet unit 1 in the accommodating groove 31. The magnets 11 in the magnet unit 1 can be more closely joined, thereby avoiding separation of the magnets 11. Magnetic induction lines of the plurality of magnets 11 in the magnet unit 1 can be directed to a predetermined path by disposing the magnetic conductive sheet 32, thereby avoiding a loss of a magnetic force of the magnet 11.

In some embodiments, as shown in FIG. 17, a bonding layer 33 is disposed between the magnet unit 1 and the groove bottom wall of the accommodating groove 31. In this way, the magnet unit 1 may be firmly fixed in the accommodating groove 31.

The bonding layer 33 may be a glue layer, for example, a thermosetting glue layer.

In addition to the Halbach array, the magnet unit 1 in embodiments of this application may alternatively be another array with the magnets 11 that repulse each other. In some embodiments, FIG. 18 is a diagram of a structure of a magnetic attraction component according to an eleventh embodiment of this application. In the magnet unit 1, each magnet 11 includes two magnet end surfaces 117 disposed opposite to each other, and first magnet side surfaces 113 and second magnet side surfaces 114 connected between the two magnet end surfaces 117, and the magnets 11 have a same pole direction that points from one of the two magnet end surfaces 117 to the other magnet end surface 117. The first magnet side surfaces 113 are separately located at the two opposite ends of the magnet 11 in the first direction X, and the first direction X is perpendicular to the arrangement direction Y of the magnets 11 in the magnet unit 1. The second magnet side surfaces 114 are separately located at the two opposite ends of the magnets 11 in the arrangement direction Y of the magnets 11, and in the two adjacent magnets 11, second magnet side surfaces 114 of the magnets 11 are connected.

Certainly, the magnet 11 is not limited to the structure shown in FIG. 18, and another shape may alternatively be used for the magnet 11 based on an actual case.

In some embodiments, as shown in FIG. 18, in the two adjacent magnets 11, the seam 12 of the first magnet side surfaces 113 of the magnets 11 has the welding bonding portion 2. Impact of high temperature or the like on an operating surface (a surface having magnetic poles, that is, the magnet end surface 117) of the magnet unit 1 in the welding process can be reduced through such a disposition, thereby reducing the impact of welding on the magnetism of the magnet unit 1.

In some embodiments, FIG. 19 is a diagram of a structure of a magnetic attraction component according to a twelfth embodiment of this application. There are a plurality of magnet units 1, pole directions of magnets 11 in two adjacent magnet units 1 are opposite, and the seam 12 of first magnet side surfaces 113 of the two adjacent magnet units 1 has the welding bonding portion 2. The welding bonding portion 2 is disposed at the seam 12 between the first magnet side surfaces 113 of the two adjacent magnet units 1. In this way, the two adjacent magnet units 1 are connected through welding and magnetic attraction, so that a connection between the two adjacent magnet units 1 can be firmer, thereby improving reliability of the connection between the magnet units 1.

As shown in FIG. 19, a quantity of magnet units 1 is two, and is certainly not limited thereto. The quantity of magnet units 1 may alternatively be three or more.

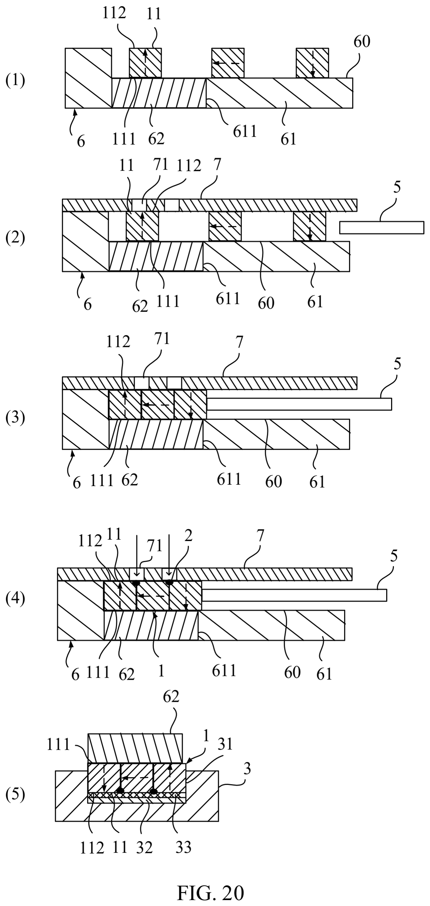

FIG. 20 is a diagram of an assembly process of a magnetic attraction component according to some embodiments of this application. An assembly method for a magnetic attraction component includes the following steps.

S1: As shown in (1) to (4) in FIG. 20, weld the two adjacent magnets 11 that repulse each other in the magnet unit 1 in the magnetic attraction component, where the magnet unit 1 includes the plurality of magnets 11, and the plurality of magnets 11 in the magnet unit 1 are placed on a carrying surface 60 of a carrier 6.

The two adjacent magnets 11 that repulse each other are welded. The connection between the magnets 11 that repulse each other is closer, and the strength of the connection is higher, thereby improving the reliability of the connection between the magnets 11 that repulse each other, and further ensuring normal operation of the magnetic attraction component. In addition, the magnets 11 that repulse each other are welded, so that a process that occupies long time, such as baking, can be omitted, thereby helping improve assembly efficiency of the magnetic attraction component.

In addition, the two magnets 11 that repulse each other are welded together, and may be welded after the two magnets 11 that repulse each other are connected. In this way, the problem that the middle magnet 021 in the assembly method shown in FIG. 6 cannot be assembled due to the overflowed glue is avoided, so that the assembly consistency of the magnet unit 1 is good.

In some embodiments, as shown in FIG. 20, the magnet unit 1 is the Halbach array, each magnet 11 includes the first end surface 111 and the second end surface 112 that are disposed opposite to each other, and the first magnet side surfaces 113 connected between the first end surface 111 and the second end surface 112, the first end surface 111 is located on the strong magnetic side of the magnet unit 1, the second end surface 112 is located on the weak magnetic side of the magnet unit 1, the first magnet side surfaces 113 are separately located at the two opposite ends of the magnet 11 in the first direction X, and the first direction X is perpendicular to the arrangement direction Y of the magnets 11 in the magnet unit 1.

Welding the two adjacent magnets 11 that repulse each other in the magnet unit 1 in the magnetic attraction component includes:
S11: As shown in (1) to (3) in FIG. 20, perform welding at a joint of welding surfaces of the two adjacent magnets 11, where the welding surface is located on a side that is of the magnet 11 and that is away from the carrying surface 60, and the welding surface is the second end surface 112.

In addition to the second end surface 112, the welding surface may alternatively be the first magnet side surface 113. As shown in (2) and (3) in FIG. 20, after the plurality of magnets 11 are disposed on the carrying surface 60 of the carrier 6, sides of the plurality of magnets 11 may be pushed and pressed via a push rod 5, so that the welding surfaces of the two adjacent magnets 11 are connected, to facilitate subsequent welding.

Welding is performed at the joint of the welding surfaces of the two adjacent magnets 11, and the welding surface is the second end surface 112 or the first magnet side surface 113. Impact of high temperature or the like on the operating surface (the surface of the strong magnetic side) of the magnet unit 1 in the welding process can be reduced through such a disposition, thereby reducing impact of welding on the magnetism of the magnet unit 1.

In some embodiments, after step S11, the method further includes:
S2: As shown in (5) in FIG. 20, place the magnet unit 1 in the accommodating groove 31 of the magnet mounting bracket 3, where the first end surface 111 of the magnet 11 is away from the groove bottom wall of the accommodating groove 31, and the bonding layer 33 is disposed between the magnet unit 1 and the groove bottom wall of the accommodating groove 31. The bonding layer 33 may be a glue layer, for example, a thermosetting glue layer.

The accommodating groove 31 can limit the location of the magnet unit 1 by disposing the magnet unit 1 in the accommodating groove 31 of the magnet mounting bracket 3. The magnets 11 in the magnet unit 1 can be more closely joined, thereby avoiding separation of the magnets 11. In addition, after the magnets 11 that repulse each other in the magnet unit 1 are welded, the magnets 11 that repulse each other are placed in the accommodating groove 31. This can avoid a problem that in the assembly method in FIG. 5, the first glue layer 031 and the second glue layer 032 that are of different materials are in contact and react, leading to detachment of the magnet unit 1 because the first glue layer 031 is not cured.

It should be noted that, in FIG. 5, a material of the second glue layer 032 is usually AB glue (AB glue, two-liquid mixed hardened glue), anaerobic glue, or the like. A material of the first glue layer 031 is thermosetting glue, and the first glue layer 031 is of a different type. The material of the second glue layer 032 is different from the material of the first glue layer 031. If the second glue layer 032 is in contact with the first glue layer 031 before the second glue layer 032 is completely cured, glue poisoning occurs. As a result, the first glue layer 031 is not cured, and the magnet unit 1 is easily detached.

In some embodiments, as shown in FIG. 20, the carrier 6 includes a carrying body 61 and a movable carrying platform 62, an accommodating hole 611 is disposed on the carrying body 61, the movable carrying platform 62 is disposed in the accommodating hole 611 and may be separated from the carrying body 61, and the movable carrying platform 62 is configured to be disposed with the magnet unit 1.

Step S2 includes the following steps.

S21: As shown in (5) in FIG. 20, separate the movable carrying platform 62 from the carrying body 61.

S22: As shown in (5) in FIG. 20, move the movable carrying platform 62 to be above of the magnet mounting bracket 3, and rotating the movable carrying platform 62 by a given angle, to enable the first end surface 111 of the magnet 11 to be away from the groove bottom wall of the accommodating groove 31 on the magnet mounting bracket 3.

As shown in FIG. 20, if the welding surface is the second end surface 112, the movable carrying platform 62 needs to be rotated by 180 degrees to reverse the magnet unit 1, so that the first end surface 111 of the magnet 11 is away from the groove bottom wall of the accommodating groove 31. If the welding surface is the first magnet side surface 113, the movable carrying platform 62 needs to be rotated by 90 degrees, so that the first end surface 111 of the magnet 11 is away from the groove bottom wall of the accommodating groove 31.

S23: Separate the movable carrying platform 62 from the magnet unit 1 to place the magnet unit 1 in the accommodating groove 31 of the magnet mounting bracket 3.

A transfer mechanism can transfer the magnet unit 1 via the movable carrying platform 62 by adopting the foregoing method. Direct contact between the transfer mechanism and the magnet unit 1 can be avoided, thereby reducing damage caused by an external force to the magnet unit 1 in a process of placing the magnet unit 1 on the magnet mounting bracket 3.

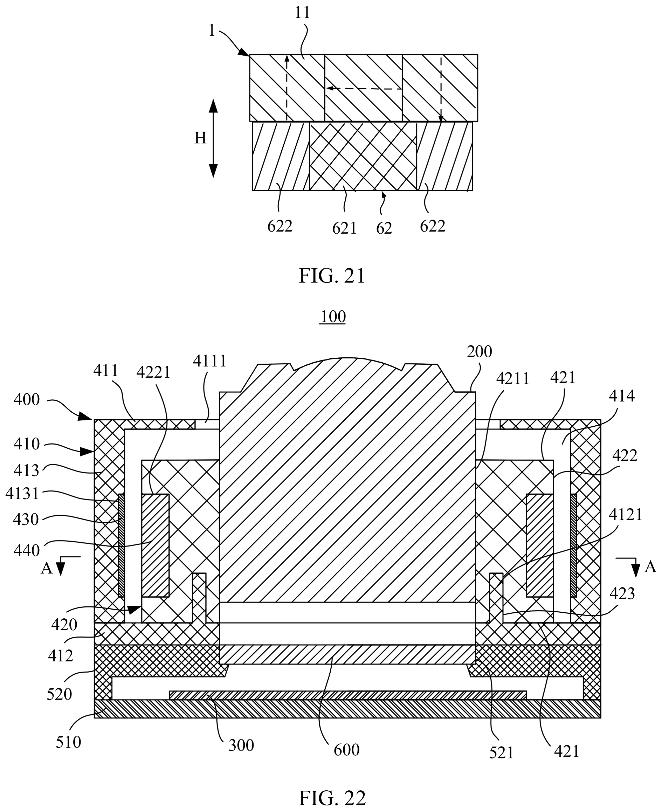

In some embodiments, FIG. 21 is a diagram of a structure of a movable carrying platform 62 according to some embodiments of this application. The movable carrying platform 62 includes a carrying platform body 621 and magnet snapping members 622 that are able to be movably disposed on two opposite sides of the carrying platform body 621, there are three magnets 11 in the magnet unit 1, a magnet 11 located in a middle is located on the carrying platform body 621, parts of magnets 11 located on two sides are located on the carrying platform body 621, the other parts of the magnets 11 are located on the corresponding magnet snapping members 622, and each magnet snapping member 622 snaps to the corresponding magnet 11.

S23: Separate the movable carrying platform 62 from the magnet unit 1 includes:
S231: As shown in (5) in FIG. 20 and FIG. 21, adjust a location of each magnetic snapping member 622 relative to the carrying platform body 621, to enable each magnetic snapping member 622 to be separated from the corresponding magnet 11.

The magnetic snapping member 622 may be connected to the carrying platform body 621 in a sliding manner in a height direction H of the carrying platform body 621, for example, via a guide rail. The magnetic snapping member 622 may slide relative to the carrying platform body 621, to adjust a location relative to the carrying platform body 621.

Adjusting a location of each magnetic snapping member 622 relative to the carrying platform body 621 may be adjusting locations of magnetic snapping members 622 relative to the carrying platform body 621 simultaneously, or sequentially adjusting locations of magnetic snapping members 622 relative to the carrying platform body 621. For example, a magnetic snapping member 622 on a left side may be enabled to slide relative to the carrying platform body 621, to separate the magnetic snapping member 622 on the left side from a magnet 11 on the left side; and a magnetic snapping member 622 on a right side is enabled to slide relative to the carrying platform body 621, to separate the magnetic snapping member 622 on the right side from a magnet 11 on the right side. In this way, the magnet unit 1 is separated from the carrying platform body 621 under gravity.

The location of each magnetic snapping member 622 relative to the carrying platform body 621 is adjusted by using the foregoing method, so that the magnet unit 1 can be separated from the carrying platform body 621. In this way, in a separation process, the transfer mechanism does not need to be in direct contact with the magnet unit 1, thereby reducing damage caused by an external force to the magnet unit 1 in a process of separating the magnet unit 1 from the movable carrying platform 62.

In some embodiments, before welding the two adjacent magnets 11 that repulse each other in the magnet unit 1 in the magnetic attraction component, the method further includes:
As shown in (2) and (3) in FIG. 20, a protection cover 7 is covered on the plurality of magnets 11, an avoidance hole 71 is disposed on the cover 7, and the avoidance hole 71 is opposite to a welding part on the magnet 11.

The protection cover 7 is covered on the plurality of magnets 11. The cover plate 7 can protect a non-welding part of the magnet 11, thereby avoiding damage caused by a welding device to the non-welding part of the magnet 11 in a welding process. In addition, the avoidance hole 71 is opposite to the welding part on the magnet 11. In this way, during welding, the welding device can accurately locate the welding part, to perform welding.

For a feature that is the same as or similar to that in the foregoing product embodiments of the magnetic attraction component and that appears in the embodiment of the assembly method for a magnetic attraction component, refer to the description in the foregoing product embodiments of the magnetic attraction component. Details are not described herein again.

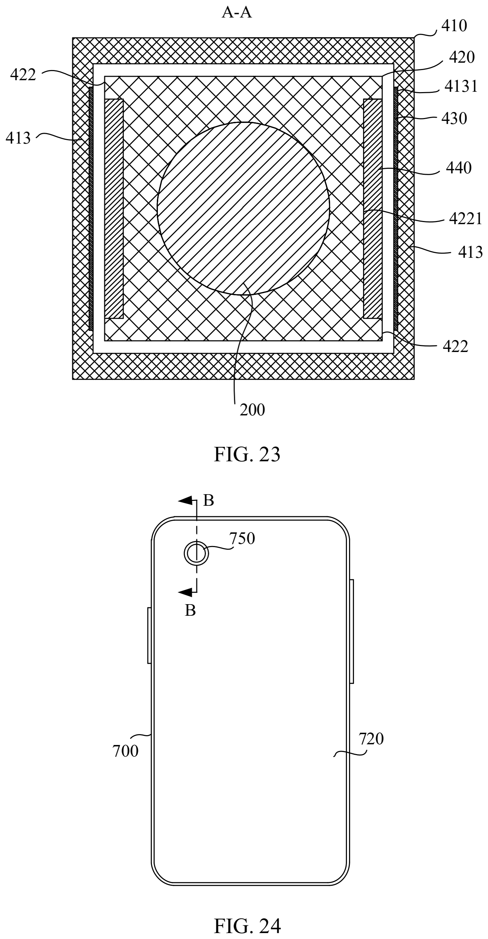

As shown in FIG. 22 and FIG. 23, FIG. 22 is a diagram of a structure of a camera 100 according to some embodiments of this application, and FIG. 23 is an A-A sectional view of the camera 100 in FIG. 22. The camera 100 includes an optical lens 200, a photosensitive element 300, and a linear motor 400.

The linear motor 400 includes a stator 410, a mover 420, a drive coil 430, and a magnetic attraction component 440 according to any one of the foregoing embodiments. The drive coil 430 is disposed on the stator 410, and the magnetic attraction component 440 is disposed on the mover 420.

The optical lens 200 is fastened to the mover 420 of the linear motor 400, the photosensitive element 300 is disposed on an image side of the optical lens 200, and the photosensitive element 300 is relatively fastened to the stator 410 of the linear motor 400 in an axial direction of the optical lens 200.

The linear motor 400 may be a voice coil motor, or may be another type of linear motor. This is not specifically limited herein.

When the linear motor 400 operates, the drive coil 430 is powered on, and a magnetic field of the magnetic attraction component 440 interacts with the drive coil 430, so that the mover 420 moves in the axial direction of the optical lens 200, thereby driving the optical lens 200 to move in the axial direction, to implement focusing of the camera 100.

As shown in FIG. 22, the photosensitive element 300 is disposed on a circuit board 510, and a photosensitive surface of the photosensitive element 300 is disposed facing a light outlet end (for example, a lower end of the optical lens 200 in FIG. 22) of the optical lens 200, to receive light passing through the optical lens 200. The photosensitive element 300 may be a charge coupled device (charge coupled device, CCD for short), or may be a complementary metal-oxide-semiconductor (Complementary Metal-Oxide-Semiconductor, CMOS for short). This is not specifically limited herein.

In some embodiments, as shown in FIG. 22, the stator 410 is of a housing structure, and includes a first stator end wall 411, a second stator end wall 412, and stator side walls 413 connected between a first end wall and a second end wall. The first stator end wall 411, the second stator end wall 412, and the stator side walls 413 enclose a housing cavity 414, a coil groove 4131 is disposed on an inner surface of the stator side walls 413, and the drive coil 430 is disposed in the coil groove 4131.

The mover 420 is of a block structure and is disposed in the housing cavity 414. The mover 420 includes two mover end walls 421 disposed opposite to each other, and mover side walls 422 connected between the two mover end walls 421. A placement groove 4221 is disposed on the mover side wall 422 at a location corresponding to the drive coil 430, and the magnetic attraction component 440 is disposed in the placement groove 4221.

A lens mounting hole 4211 is disposed on the mover end walls 421, and the lens mounting hole 4211 is configured to mount the optical lens 200. A lens avoidance hole 4111 is disposed at a location corresponding to the lens mounting hole 4211 on the first stator end wall 411, and the lens avoidance hole 4111 is configured to avoid the optical lens 200.

In some embodiments, as shown in FIG. 22 and FIG. 23, magnetic attraction components 440 are separately disposed on the mover side walls 422 on two opposite sides of the mover 420, drive coils 430 are separately disposed on the stator side walls 413 on two opposite sides of the stator 410, and a location of each magnetic attraction component 440 corresponds to the drive coil 430 on the stator side wall 413 on one side. When the linear motor 400 operates, the two opposite sides of the mover 420 are affected by a driving force through such a disposition, so that a force of the mover 420 is balanced, and motion of the mover 420 is more stable.

In some embodiments, as shown in FIG. 22, a guide pillar 4121 is disposed on the second stator end wall 412, the guide pillar 4121 extends in an axial direction of the lens mounting hole 4211, a guide hole 423 is disposed on the mover end wall 421 on a side close to the second stator end wall 412, and the guide pillar 4121 is matched with the guide hole 423 in a sliding manner. When the linear motor 400 operates, the guide pillar 4121 can guide the mover 420 through such a disposition, so that the mover 420 moves more smoothly.

In some embodiments, as shown in FIG. 22, there are two guide pillars 4121, the two guide pillars 4121 are respectively located on two opposite sides of the lens mounting hole 4211, there are two guide holes 423, and each guide pillar 4121 is separately matched with a corresponding guide hole 423 in the sliding manner. The mover 420 can maintain balance through such a disposition, so that the mover 420 moves more smoothly.

Certainly, the mover 420 and the stator 410 are not limited to the foregoing structures, and may alternatively be set to other structures based on an actual case. Disposing locations of the drive coil 430 and the magnetic attraction component 440 may alternatively be exchanged. In other words, the drive coil 430 is disposed on the mover 420, and the magnetic attraction component 440 is disposed on the stator 410.

In some embodiments, as shown in FIG. 22, the stator side wall 413 and the first stator end wall 411 are of an integrated structure, and the second stator end wall 412 is detachably connected to the stator side wall 413. In this way, when at least one of the mover 420, the drive coil 430, and the magnetic attraction component 440 in the housing cavity 414 is damaged, the second stator end wall 412 and the stator side wall 413 may be disassembled, to facilitate maintenance and replacement of the mover 420, the drive coil 430, and the magnetic attraction component 440 in the housing cavity 414.

The second stator end wall 412 may be detachably connected to the stator side wall 413 through a screw connection, a clamping connection, bonding, or the like. This is not specifically limited herein.

In some embodiments, as shown in FIG. 22, the camera 100 further includes a light filter 600. The light filter 600 is disposed between the optical lens 200 and the photosensitive element 300. The light filter 600 is configured to filter out an unnecessary band in light, to prevent the photosensitive element 300 from generating a false color or a ripple, to improve effective resolution and color restoration of the photosensitive element 300. For example, as shown in FIG. 22, the light filter 600 is an infrared light filter 600.

In some embodiments, as shown in FIG. 22, the camera 100 further includes a mounting base 520. The mounting base 520 is fastened to the stator 410. A light filter mounting hole 521 is disposed on the mounting base 520, and the light filter 600 is mounted in the light filter mounting hole 521. Certainly, the light filter 600 is not limited to being mounted on the mounting base 520, and may alternatively be mounted on the stator 410 or the optical lens 200.

The mounting base 520 may be fastened to the stator 410 through a screw connection, a clamping connection, bonding, or the like. This is not specifically limited herein.

The magnetic attraction component 440 in this embodiment of this application is not limited to being applied to the linear motor 400, and may be further applied to a magnetic attraction apparatus, for example, a magnetic keyboard, a magnetic phone holder, a door latching apparatus of a home appliance (such as a refrigerator), or a magnetic glass wiper.

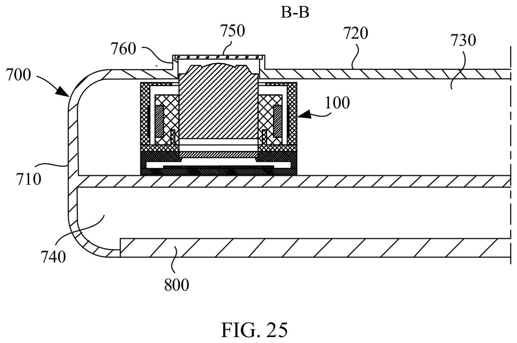

As shown in FIG. 24 and FIG. 25, FIG. 24 is a diagram of a back of an electronic device according to some embodiments of this application, and FIG. 25 is a B-B cross-sectional view of the electronic device shown in FIG. 24. The electronic device is a mobile phone, and includes a housing 700 and the camera 100 shown in any one of the foregoing embodiments. The camera 100 is disposed on the housing 700.

In some embodiments, as shown in FIG. 25, the housing 700 includes a middle frame 710 (also referred to as a front housing or a front frame) and a rear cover 720 (also referred to as a battery cover). A display 800 and the rear cover 720 are respectively mounted on two opposite sides of the middle frame 710. The rear cover 720 and the middle frame 710 form first accommodating space 730. The camera 100 is a rear-facing camera 100 and is disposed in the first accommodating space 730. A light incident end of the optical lens 200 of the camera 100 is disposed opposite to a camera window 750 disposed on the rear cover 720, to ensure that the optical lens 200 can receive light emitted by a photographed object outside the housing 700.

The camera window 750 may be directly disposed on the rear cover 720. As shown in FIG. 25, the camera window 750 may alternatively be disposed on a camera decoration member 760. Specifically, the camera decoration member 760 is disposed on the rear cover 720, an opening is disposed on one side of the camera decoration member 760, a protection cover is disposed at the opening, and a transparent region of the protection cover is the camera window 750. As shown in FIG. 25, the camera decoration member 760 and the rear cover 720 may be of an integrated structure, but this is not limited thereto. The camera decoration member 760 and the rear cover 720 may alternatively be designed separately.

The display 800 and the middle frame 710 form second accommodating space 740. The second accommodating space 740 is configured to dispose an electronic component such as a mainboard. The mainboard is separately connected to the display 800 and the camera 100 via a flexible circuit board.

The middle frame 710 and the rear cover 720 may be detachably connected, or may be of an integrated structure. This is not specifically limited herein. The display 800 may be a liquid crystal display 800, or may be an OLED (Organic Light-Emitting Diode, organic light-emitting diode) display 800. This is not specifically limited herein.

The camera 100 in embodiments of this application may be mounted in an upper left corner, a middle upper part, or an upper right corner of a back of the electronic device. This is not specifically limited herein. In addition to that the camera 100 is mounted on the back of the electronic device and is used as the rear-facing camera, the camera 100 may alternatively be used as a front-facing camera of the electronic device.

The electronic device in this embodiment of this application is not limited to a mobile phone, and may alternatively be an electronic device having a camera, such as a tablet computer, a notebook computer, or a wearable device (such as a smartwatch). For another type of electronic device, refer to a structure of the mobile phone embodiment. Details are not described herein again.

A type of section line in the accompanying drawings of this application is used to distinguish between different components, and should not be understood as a limitation on a component material. The accompanying drawings of this application are intended to show composition of structures, and are not shown according to proportions of actual products.

Although this application is described with reference to some embodiments, it does not mean that a characteristic of this application is limited only to this implementation. On the contrary, a purpose of describing this application with reference to an implementation is to cover another option or modification that may be derived according to claims of this application. To provide an in-depth understanding of this application, the foregoing descriptions include a plurality of specific details. This application may be alternatively implemented without using these details. In addition, to avoid confusion or blurring a focus of this application, some specific details are omitted from the description. It should be noted that embodiments in this application and the features in embodiments may be mutually combined in the case of no conflict.

The terms "first", "second", "third", "fourth", and "fifth" in embodiments of this application are merely intended for a purpose of description, and shall not be understood as an indication or implication of relative importance or implicit indication of a quantity of indicated technical features. Therefore, a feature limited by "first", "second", "third", "fourth", or "fifth" may explicitly or implicitly include one or more features.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between associated objects.

In the descriptions of embodiments of this application, it should be noted that terms "mounting" and "connection" should be understood in a broad sense unless there is a clear stipulation and limitation. For example, "connection" may be a detachable connection, a non-detachable connection, a direct connection, or an indirect connection through an intermediate medium. The orientation terms mentioned in embodiments of this application, for example, "up", "down", "left", "right", "inside", and "outside", are merely directions based on the accompanying drawings. Therefore, the orientation terms are used to better and more clearly describe and understand embodiments of this application, instead of indicating or implying that a specified apparatus or element should have a specific orientation and be constructed and operated in a specific orientation. Therefore, this cannot be understood as a limitation on embodiments of this application. "A plurality of" means at least two.

Reference to "an embodiment", "some embodiments", or the like described in this specification means that one or more embodiments of this application include a specific feature, structure, or characteristic described with reference to embodiments. Therefore, statements such as "in an embodiment", "in some embodiments", "in some other embodiments", and "in other embodiments", that appear at different places in this specification do not necessarily mean referring to a same embodiment, instead, they mean "one or more but not all of embodiments", unless otherwise specifically emphasized. The terms "include", "contain", "have", and other variants thereof all mean "include but are not limited to", unless otherwise specifically emphasized in another manner.

Finally, it should be noted that the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A magnetic attraction component, comprising a magnet unit (1), wherein the magnet unit (1) comprises a plurality of magnets (11), and in the plurality of magnets (11), two adjacent magnets (11) that repulse each other are welded.

2. The magnetic attraction component according to claim 1, wherein
a joint of the two adjacent magnets (11) that repulse each other has a welding bonding portion (2), and the welding bonding portion (2) connects the two adjacent magnets (11) that repulse each other together.

3. The magnetic attraction component according to claim 2, wherein
the magnet unit (1) is a Halbach array, each magnet (11) comprises a first end surface (111) and a second end surface (112) that are disposed opposite to each other, and first magnet side surfaces (113) connected between the first end surface (111) and the second end surface (112), the first end surface (111) is a surface of the magnet (11) on a strong magnetic side of the magnet unit (1), and the second end surface (112) is a surface of the magnet (11) on a weak magnetic side of the magnet unit (1);
the first magnet side surfaces (113) are separately located at two opposite ends of the magnet (11) in a first direction (X), and the first direction (X) is perpendicular to an arrangement direction (Y) of the magnets (11) in the magnet unit (1); and
in the two adjacent magnets (11), a joint of the first magnet side surfaces (113) of the magnets (11) has the welding bonding portion (2), and/or a joint of the second end surfaces (112) of the magnets (11) has the welding bonding portion (2).

4. The magnetic attraction component according to claim 3, wherein
the magnet unit (1) comprises two magnets (11), the two magnets (11) are a first magnet (11m) and a second magnet (11n), the first magnet (11m) comprises a first magnet subportion (115) and a second magnet subportion (116), the first magnet subportion (115) and the second magnet subportion (116) are of an integrated structure, the second magnet subportion (116) is located between the first magnet subportion (115) and the second magnet (11n), a pole direction of the first magnet subportion (115) is opposite to a pole direction of the second magnet (11n), and a pole direction of the second magnet subportion (116) is perpendicular to the pole direction of the first magnet subportion (115).

5. The magnetic attraction component according to claim 2, wherein
in the magnet unit (1), each magnet (11) comprises two magnet (11) end surfaces disposed opposite to each other, and first magnet side surfaces (113) connected between the two magnet (11) end surfaces, and the magnets (11) have a same pole direction that points from one of the two magnet (11) end surfaces to the other magnet (11) end surface;
the first magnet side surfaces (113) are separately located at two opposite ends of the magnet (11) in a first direction (X), and the first direction (X) is perpendicular to an arrangement direction (Y) of the magnets (11) in the magnet unit (1); and
in the two adjacent magnets (11), a joint of the first magnet side surfaces (113) of the magnets (11) has the welding bonding portion (2).

6. The magnetic attraction component according to claim 5, wherein
there are a plurality of magnet units (1), the plurality of magnet units (1) are arranged in the arrangement direction (Y), pole directions of magnets (11) in two adjacent magnet units (1) are opposite, and a joint of the first magnet side surfaces (113) of the two adjacent magnet units (1) has the welding bonding portion (2).

7. The magnetic attraction component according to any one of claims 2 to 6, wherein
the welding bonding portion (2) is of a strip structure and extends along a seam (12) between the magnets (11).

8. The magnetic attraction component according to claim 7, wherein
the welding bonding portion (2) is in a wave shape along the seam (12).

9. The magnetic attraction component according to claim 7 or 8, wherein
an end portion of the welding bonding portion (2) is disposed at an interval from an edge of the magnet (11) along the seam (12).

10. The magnetic attraction component according to any one of claims 2 to 6, wherein there are a plurality of welding bonding portions (2), and the plurality of welding bonding portions (2) are spaced along seams (12) between the magnets (11).

11. The magnetic attraction component according to claim 10, wherein
the welding bonding portion (2) has a spiral pattern (23), and the pattern (23) extends from a central region of the welding bonding portion (2) to an edge region of the welding bonding portion (2).

12. The magnetic attraction component according to any one of claims 1 to 11, wherein
the magnetic attraction component further comprises a magnet mounting bracket (3), an accommodating groove (31) is disposed on the magnet mounting bracket (3), a groove bottom wall of the accommodating groove (31) is covered with a magnetic conductive sheet (32), and at least a part of the magnet unit (1) is disposed in the accommodating groove (31).

13. A linear motor, comprising a stator (410), a mover (420), a drive coil (430), and the magnetic attraction component (440) according to any one of claims 1 to 12, wherein the drive coil (430) is disposed on one of the stator (410) and the mover (420), and the magnetic attraction component (440) is disposed on the other of the stator (410) and the mover (420).

14. A camera, comprising an optical lens (200), a photosensitive element (300), and the linear motor (400) according to claim 13, wherein the optical lens (200) is fastened to the mover (420) of the linear motor (400), the photosensitive element (300) is disposed on an image side of the optical lens (200), and the photosensitive element (300) is relatively fastened to the stator (410) of the linear motor (400) in an axial direction of the optical lens (200).

15. An electronic device, comprising a housing (700) and the camera (100) according to claim 14, wherein the camera (100) is disposed on the housing (700).

16. An assembly method for a magnetic attraction component, comprising:
welding two adjacent magnets (11) that repulse each other in a magnet unit (1) in the magnetic attraction component, wherein
the magnet unit (1) comprises a plurality of magnets (11), and the plurality of magnets (11) in the magnet unit (1) are placed on a carrying surface (60) of a carrier (6).

17. The assembly method for a magnetic attraction component according to claim 16, wherein
the magnet unit (1) is a Halbach array, each magnet (11) comprises a first end surface (111) and a second end surface (112) that are disposed opposite to each other, and first magnet side surfaces (113) connected between the first end surface (111) and the second end surface (112), the first end surface (111) is located on a strong magnetic side of the magnet unit (1), the second end surface (112) is located on a weak magnetic side of the magnet unit (1), the first magnet side surfaces (113) are separately located at two opposite ends of the magnet (11) in a first direction (X), and the first direction (X) is perpendicular to an arrangement direction (Y) of the magnets (11) in the magnet unit (1); and
welding the two adjacent magnets (11) that repulse each other in the magnet unit (1) in the magnetic attraction component comprises:
performing welding at a joint of welding surfaces of the two adjacent magnets (11), wherein
the welding surface is located on a side that is of the magnet (11) and that is away from the carrying surface (60), and the welding surface is the second end surface (112) or the first magnet side surface (113).

18. The assembly method for a magnetic attraction component according to claim 17, wherein
the carrier (6) comprises a carrying body (61) and a movable carrying platform (62), an accommodating hole (611) is disposed on the carrying body (61), the movable carrying platform (62) is disposed in the accommodating hole (611) and may be separated from the carrying body (61), and the movable carrying platform (62) is configured to be disposed with the magnet unit (1); and
after welding is performed at the joint of the welding surfaces of the two adjacent magnets (11), the method further comprises:
separating the movable carrying platform (62) from the carrying body (61);
moving the movable carrying platform (62) to be above of the magnet mounting bracket (3), and rotating the movable carrying platform (62) by a given angle, to enable the first end surface (111) of the magnet (11) to be away from a groove bottom wall of an accommodating groove (31) on the magnet mounting bracket (3); and
separating the movable carrying platform (62) from the magnet unit (1) to place the magnet unit (1) in the accommodating groove (31).

19. The assembly method for a magnetic attraction component according to claim 18, wherein
the movable carrying platform (62) comprises a carrying platform body (621) and magnet snapping members (622) that are able to be movably disposed on two opposite sides of the carrying platform body (621), there are three magnets (11) in the magnet unit (1), a magnet (11) located in a middle is located on the carrying platform body (621), parts of magnets (11) located on two sides are located on the carrying platform body (621), the other parts of the magnets (11) are located on the corresponding magnet snapping members (622), and each magnet snapping member (622) snaps to the corresponding magnet (11); and
separating the movable carrying platform (62) from the magnet unit (1) comprises:
adjusting a location of each magnetic snapping member (622) relative to the carrying platform body (621), to enable each magnetic snapping member (622) to be separated from the corresponding magnet (11).

20. The assembly method for a magnetic attraction component according to any one of claims 16 to 19, wherein
before welding the two adjacent magnets (11) that repulse each other in the magnet unit (1) in the magnetic attraction component, the method further comprises:
covering a protection cover (7) on the plurality of magnets (11), wherein
an avoidance hole (71) is disposed on the cover, and the avoidance hole (71) is opposite to a welding part on the magnet (11).
